# EUROPEAN PATENT APPLICATION

(11) **EP 3 996 151 A1**
(43) Date of publication of application: **11.05.2022**
(21) Application number: 20206492.9
(22) Date of filing: 09.11.2020
(51) Int. Cl.: H01L 31/055

(54) **AN ADD-ON STRUCTURE FOR A PHOTOVOLTAIC CELL**

(71) Applicant: Podgorski, Adam, London SW7 5BX (GB)
(72) Inventor: Podgorski, Adam, London SW7 5BX (GB)
(74) Representative: AWA Sweden AB

(57) **Abstract**

An add-on structure 1 for a photovoltaic cell, wherein said add-on structure 1 is for being positioned between incident radiation and the photovoltaic cell 2, and wherein said add-on structure 1 comprises a host structure HS comprising an upconversion dopant UD and a downconversion or downshifting dopant DD.

## Description

### Technical field

The present disclosure relates to ways of improving performance of photovoltaic cells.

### Background

Various types of photovoltaic (PV) cells are known for use in production of electricity from incident radiation, such as solar radiation. The manufacturing cost of the PV cells greatly affect their relevance for production of electricity. The most efficient PV cell technologies may prove too expensive to be viable for large-scale production of electricity, whilst they may be interesting for production of energy where space is limited, such as on satellites. Less expensive PV cell technologies may not be the most efficient, but they provide lower production cost for a given amount of electricity produced.

Apart from mere cost aspects, other aspects affect the design of the PV cell.

For example, the environment in which the PV cell is to be used affects the requirements as to durability and waterproofness. Also, PV cells are sometimes exerted to rain and dust, which prevents incident radiation from reaching the PV cell and thereby lowers the electric output of the PV cell.

Another challenge is the large upfront cost associated with large-scale production of PV cells and panels comprising the PV cells.

Crystalline silicon provides economically viable solar production today, with multijunction solar cells offering more output at a higher cost. Hybrid organic-inorganic perovskite solar cells are a promising low-cost alternative but are still in their early stages.

### Summary

Accordingly, an object of the invention is to provide for lower cost electricity production using PV-cells.

According to a first aspect of the present disclosure this and other objects are achieved by an add-on structure according to claim 1 to be positioned between incident radiation and a photovoltaic cell. The photovoltaic cell may for example be any of the following cells: crystalline silicon, polycrystalline silicon, gallium arsenide, amorphous silicon, copper indium gallium (di)selenide, perovskite, organic or quantum dot.

Alternative embodiments of the add-on structure are defined in the dependent claims.

The add-on structure comprises:
a host structure comprising an upconversion dopant and a downconversion or downshifting dopant.
The upconversion dopant and downconversion or downshifting dopants enable harvesting by the photovoltaic cell of the lower and higher portions of the spectrum of incident radiation, thereby increasing the electric output power of the photovoltaic cell.

The host structure may comprise an outer layer with the downconversion or downshifting dopant, and an inner layer with the upconversion dopant, wherein the downconversion or downshifting dopant is chosen to downconvert or downshift incident UV-light.
By providing the downconversion or downshifting dopant in a layer outside the upconversion dopant, UV-light is downconverted or downshifted before reaching the inner layer, thereby mitigating UV-browning of the inner layer, which in turn increases lifetime of the PV module and add-on structure.

The add-on structure may further comprise an anti-reflective layer provided on the microlens layer or provided on an outside of the add-on structure for receiving incident radiation before it reaches the rest of the add-on structure. The anti-reflective layer acts to increase the amount of incident radiation not reflected and thus transported further into the add-on structure where it can be converted to electricity by the PV cell.

the anti-reflective layer may comprise hydrophobic silica nanoparticles and organosilica binders. The combination of hydrophobic silica nanoparticles and organosilica binders function as a combined hydrophobic layer and an anti-reflective coating.

The add-on structure according may further comprise a hydrophobic structure comprising parallel spaced-apart ridges, said ridges being sized and spaced-apart such that they provide hydrophobic properties to the add-on structure, for example using a 50-100 micrometer spacing between ridges.
The hydrophobic structure causes rain and other types of oncoming water to pearl and run off and thereby provides for self-cleaning of the add-on structure which in turn leads to increased long-term efficiency and reduced maintenance need of the photovoltaic cell to which the add-on structure is used.

The space-apart ridges of the hydrophobic structure may be formed in the host structure.
Forming the hydrophobic structure in the host-layer is space-efficient since no additional layer is needed for provision of the parallel spaced apart ridges causing the hydrophobic effect. Also, since no additional layer is needed, the number of steps of the manufacturing process is kept low.

The spaced-apart ridges of the hydrophobic structure may be provided in a transparent or translucent layer on the outside of the host structure.

Forming the hydrophobic structure in a transparent or translucent layer on the outside of the host structure enables even thickness of the host structure and thereby an even up- and downconversion or downshifting effect over the extent of the add-on structure.
The downconversion or downshifting dopant may be chosen from a first group comprising:
- organosilane-functionalized carbon nano dots (Si-CNDs) crosslinked in the siloxane matrix,
- core-shell chalcogenide quantum dots (Cds/CdSe), and
- CuInS2/ZnS quantum dots.

The upconversion dopant may be chosen from a second group comprising:
- nitrogen doped graphene quantum dot
- lanthanide-doped upconversion nanoparticles, and
- fluorescent semiconducting nanocrystals.

The host structure may comprise a matrix substance in which the downconversion or downshifting dopant is embedded. The matrix substance is chosen from a third group comprising:
- P(LMA-co-EGDMA),
- PMMA,
- PC, and
- PVA.

These groups of dopants are suitable for use with solar radiation and some conventional photovoltaic cell types, such as crystalline silicon, polycrystalline silicon and CIGS.

In an embodiment, the downconversion or downshifting dopant is organosilane-functionalized carbon nano dots (Si-CNDs) crosslinked in the siloxane matrix, wherein the upconversion dopant is nitrogen-doped graphene quantum dot, and wherein the matrix substance is PMMA.

The add-on structure may further comprise a microlens layer provided on the outer side of the host structure, wherein the microlens layer is configured to concentrate incident light into the host structure.
The efficiency of the upconversion is increased by the concentration/focusing action provided by the microlens layer since the significant excitation levels required by upconversion dopants are more easily reached when incident light is concentrated at the upconversion dopant.

The microlens layer may be provided on an outer surface of the hydrophobic structure.
The outer surface of the hydrophobic structure is accessible for formation of the microlenses after the hydrophobic structure has been provided. Forming the microlens layer on the outer surface of the hydrophobic structure enables concentration of incident radiation with sustained hydrophobic properties of the add-on structure since the microlenses are small relative to the size of the spaced-apart ridges.

The microlens layer may comprise an array of microlenses in the form of parallel ridges shaped for said concentration of light into the host structure. The parallel ridges can be formed by mold manufacturing, which is an efficient manufacturing method. Hence, the proposed shape of the microlens array enables lower manufacturing cost.

The microlens layer may comprise a two-dimensional array of microlenses. The two-dimensional array of microlenses enables each microlens to focus light in a unique direction with a controlled focal length, thereby enabling improved control of where light is to be focused at each portion of the microlens structure.

The add-on structure may further comprise a first wavelength-selective mirror layer adapted for reflecting emission peak wavelengths of the downconversion or downshifting dopant, wherein the first wavelength-selective mirror layer is provided outside of the downconversion or downshifting dopant for reflecting radiation from the downconversion or downshifting dopant towards the photovoltaic cell. A part of the isotropic radiation emitted from the downconversion or downshifting dopant is directed away from the photovoltaic cell/panel and the first wavelength-selective layer reflects this radiation back towards the photovoltaic cell/panel, such that a larger portion of radiation emitted from the downconversion or downshifting dopant reaches the photovoltaic cell/panel. Hence, the first wavelength-selective layer decreases downconversion/downshifting energy losses.

The position outside of the downconversion or downshifting dopant refers to a position which is not between the dopant and the PV-cell but on the other side of the dopant, facing the incoming radiation. Hence, the outside is closer to incoming (solar) radiation and likewise the inside of the dopant refers to the side of the dopant closer to the PV-cell.

The add-on structure may further comprise a second wavelength-selective mirror layer adapted for reflecting emission peak wavelengths of the upconversion dopant. The second wavelength-selective mirror layer is provided outside of the layer comprising the upconversion dopant for reflecting radiation from the upconversion dopant towards the photovoltaic cell. A part of the radiation emitted from the upconversion dopant is directed away from the photovoltaic cell/panel and the first wavelength-selective layer reflects this radiation back towards the photovoltaic cell/panel, such that a larger portion of radiation emitted from the upconversion dopant reaches the photovoltaic cell/panel. Hence, the first wavelength-selective layer decreases upconversion energy losses.

The position outside of the upconversion dopant refers to a position which is not between the dopant and the PV-cell but on the other side of the dopant, facing the incoming (solar) radiation. Hence, the outside is closer to incoming (solar) radiation and likewise the inside of the dopant refers to the side of the dopant closer to the PV-cell.

A mirror reflecting all wavelengths would be able to reflect substantially all light emitted by dopants away from the PV cell back towards the PV cell. However, such a mirror would not be able to let through incident radiation and would thus render the add-on structure inoperable. The wavelength-selective mirror(s) lets a great amount of incident radiation through to reach the dopants and the PV-cell whilst reflecting radiation to the PV-cell which would otherwise have been lost. By adapting the wavelength-selective mirrors to reflecting the emission peak wavelengths of the upconversion dopant and of the downconversion or downshifting dopant respectively, a great amount of energy can be redirected back to the PV cell whilst also letting a great amount of incident radiation pass from outside through the wavelength-selective mirror and into the host structure comprising the dopants.

### Brief description of drawings

Fig. 1 shows an add-on structure according to a first embodiment of the present disclosure.
Fig. 2 shows an add-on structure according to a second embodiment of the present disclosure but also provided with a microlens layer comprising a microlens array on the outside of the add-on structure, i.e. facing incident radiation.
Fig. 3 shows an add-on structure according to a third embodiment of the disclosure corresponding to the second embodiment but also provided with a wavelength-selective mirror layer outside of the microlens layer.
Fig. 4 shows an add-on structure according to a fourth embodiment of the disclosure corresponding to the second embodiment but also provided with a wavelength-selective mirror layer between the host structure and the microlenses.
Fig. 5 shows an add-on structure according to a fifth embodiment of the disclosure corresponding to the second embodiment but also provided with an anti-reflective layer outside of the wavelength-selective mirror layer.
Fig. 6 shows an add-on structure according to a sixth embodiment of the disclosure corresponding to the third embodiment but also provided with an anti-reflective layer outside of the microlens layer.
Figs. 7, 8 and 9 shows embodiments modified by the provision of a hydrophobic structure.

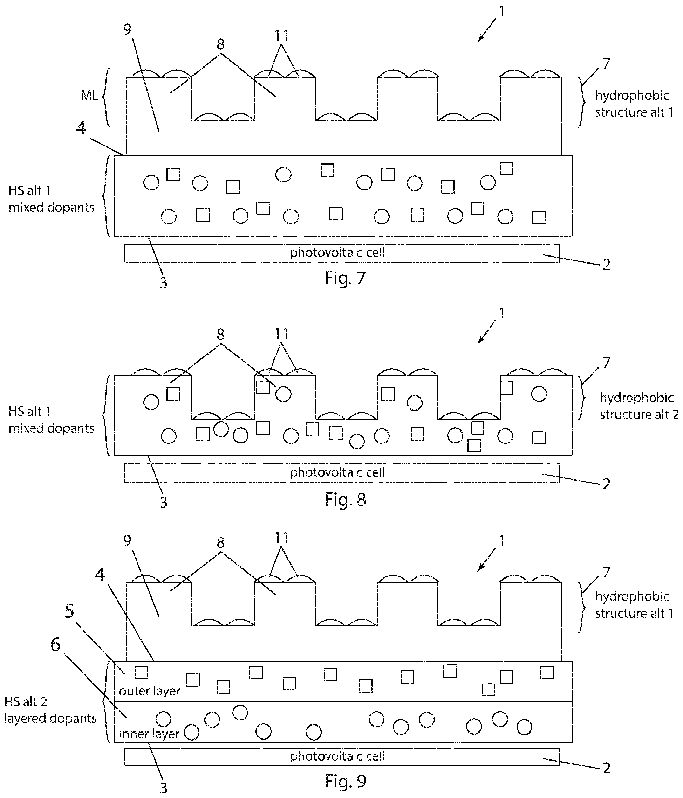

Figs. 7 and 9 shows the provision of an additional layer for providing the hydrophobic structure whilst fig. 8 shows that the hydrophobic structure can instead be provided directly in the host structure by shaping the host structure accordingly.

Also, fig. 9 shows that the upconversion dopant and the downconversion or downshifting dopant of the host structure can be provided separated into two layers with the downconversion or downshifting dopant provided outside of the layer comprising the upconversion dopant, i.e. closer to incident solar radiation.

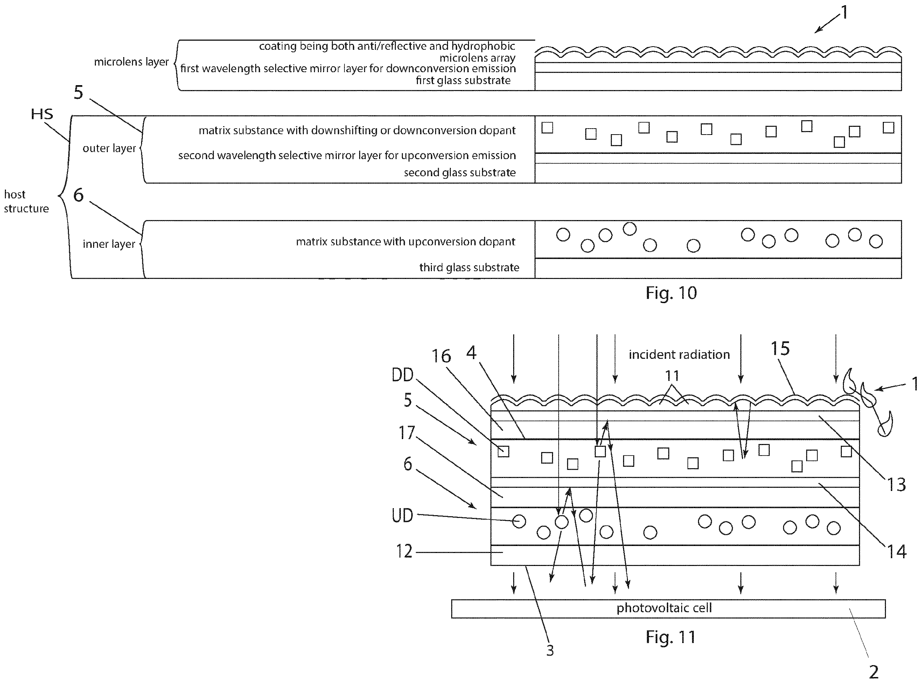

Figs. 10 and 11 both show an add-on structure according to a seventh embodiment comprising an outer layer being both hydrophobic and anti-reflective.

Specifically, Fig. 11 shows schematically an exploded view of the add-on structure with layers split according to parts manufactured separately to then be stacked form the add-on structure as shown in fig. 10. Although glass substrates are shown in each layer, it may be possible to manufacture the add-on structure with fewer glass substrates or without glass substrates, largely depending on the choice of production methods for adding the various layers and their compounds.

| | |
|---|---|
| 1 | add-on structure for photovoltaic cell/panel |
| 2 | photovoltaic cell/panel |
| 3 | inner side of host structure |
| 4 | outer side of host structure |
| 5 | outer layer of host structure |
| 6 | inner layer of host structure |
| 7 | hydrophobic structure |
| 8 | parallel spaced-apart ridges of hydrophobic structure |
| 9 | transparent or translucent layer with hydrophobic structure |
| 10 | matrix substance |
| 11 | parallel spaced-apart ridges of microlens array |
| 12 | third glass substrate |
| 13 | first wavelength-selective mirror layer |
| 14 | second wavelength-selective mirror layer |
| 15 | hydrophobic and/or anti-reflective layer |
| 16 | first glass substrate |
| 17 | second glass substrate |
| HS | host structure |
| UD | upshifting dopant |
| DD | downconversion or downshifting dopant |
| ML | microlens layer |

### Detailed description

### Add-on structure

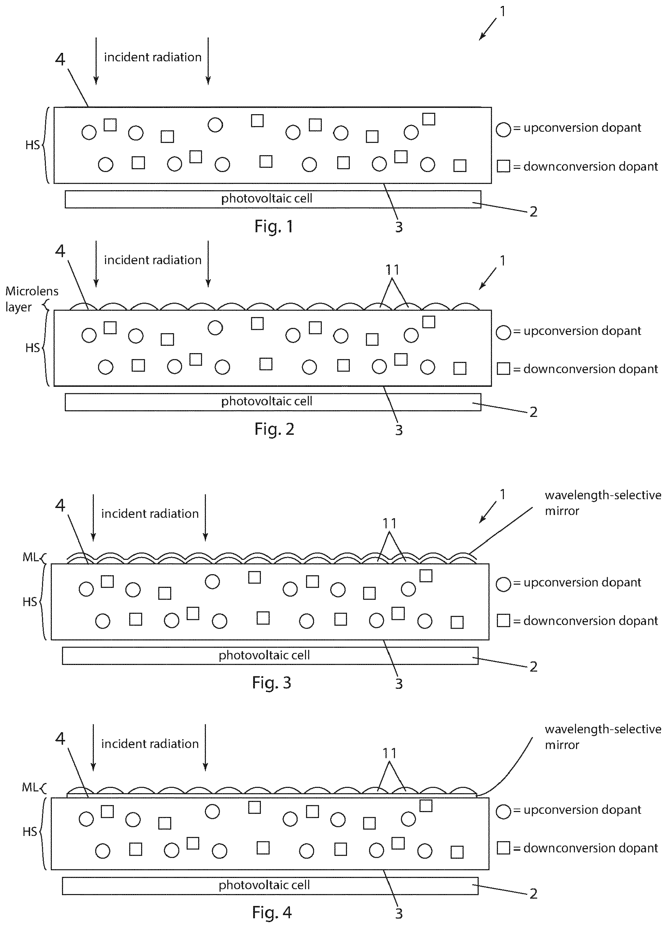

The add-on structure 1 is for use with a photovoltaic cell 2, such as a crystalline silicon, gallium arsenide, amorphous silicon, copper indium gallium (di)selenide, perovskite, organic, quantum dot, or any other suitable type of photovoltaic cell or panel comprising such cell(s). The add-on structure 1 is to be added on the cell or panel such that it is positioned between incident radiation and the photovoltaic cell/panel, as for example shown in fig. 1. The purpose of the add-on structure 1 is to improve the performance of the photovoltaic cell 2 by a suitable combination of light-management techniques. Hence, the use of the add-on structure 1 together with lower-cost photovoltaic cells, such as mono- and polycrystalline silicon, enables the photovoltaic cells 2 to perform better, thus increasing their performance-to-cost ratio.

It should be understood that the use of the wording 'layer' refers generally to a portion of the add-on structure 1, which can comprise one or more layers/sheets of one or more compounds/materials. A layer thus does not have to be physically separated from other layers, although it could be. Typically, a layer is thus described with reference to its function and/or position/hierarchy within the add-on structure 1 and should not be construed as implying a specific shape or bonding/separation to other layers. Please refer to the schematic figures 1-10 for examples of layers discussed.

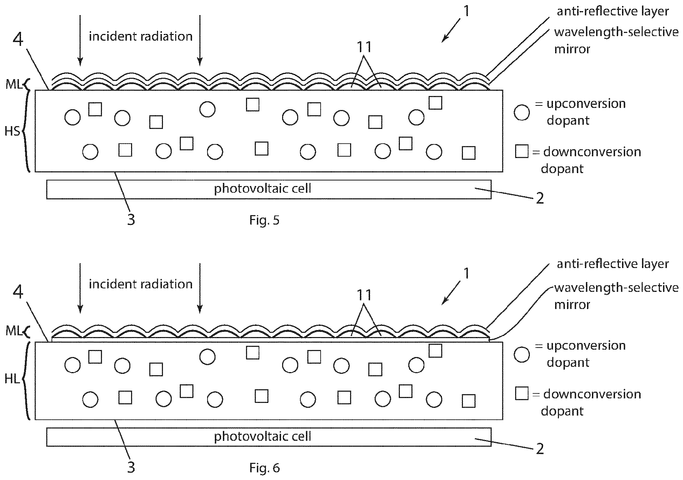

Also, an outer surface or outer side refers generally to a surface or side of a layer or structure facing away from the photovoltaic cell/panel 2. Likewise, an inner surface or side refers generally to a surface or side facing the photovoltaic cell/panel 2. Accordingly, an outside/outer side of a layer can also be covered by some other structure or layer and should then still be understood as facing away from the photovoltaic cell 2 despite being 'covered' by the other layer or structure. For example, the outside/outer side of the host structure HS of the embodiment of fig. 6 is the uppermost perimeter of the host structure HS depicted and it is covered by the wavelength-selective mirror 13, 14. By providing a 'first layer' outside of a 'second layer', the 'first layer' is thus able to act manage incident radiation before the radiation reaches the 'second layer'. Also, by providing a 'third layer' outside a 'fourth layer', the 'third layer' is able to reflect radiation from the 'fourth layer' back towards the 'third layer' in a direction towards the photovoltaic cell/panel 2.

Before describing specific embodiments in greater detail, a general discussion of the various light-management techniques involved will be given below.

### Dopants

All embodiments of the add-on structure comprise a host structure HS comprising an upconversion dopant UD and a downconversion or downshifting dopant DD. The host structure HS has an inner side for facing the photovoltaic cell/panel 2 and an outer side for facing away from the photovoltaic cell 2, i.e. towards incident solar radiation.

Together or separately, the upconversion dopant UD and the downconversion dopant DD are brought into/onto a matrix substance 10 being PMMA or any other suitable material and forming it into one or more layers/sheets, each layer/sheet comprising at least one of the dopants as appropriate. The matrix substance 10 and its dopants DD, UD could be applied on top of some other transparent layer, such as on a glass substrate, or the matrix substance 10 could form a self-supporting layer to be joined or stacked with other layers. The glass substrate may have been previously treated with one or more layers of other compounds for providing additional light management functions.

Thus, in some embodiments the upconversion dopant is provided in one layer and the downconversion or downshifting dopant in another layer; In other embodiments, the dopants are provided in one layer, such as by mixing them into PMMA and forming a layer.

Although any suitable downconversion or downshifting dopant DD may be chosen, typical alternatives to consider are P(LMA-co-EGDMA), PMMA, PC, or PVA.

### Hydrophobic properties

Giving the add-on structure 1 hydrophobic properties is advantageous in that in enables improved self-cleaning of the add-on structure 1, thereby improving long-term efficiency of the photovoltaic cell/panel 2 in front of which the add-on structure 1 is used. The hydrophobic properties enable rain/water to wash away foreign particles from the outer surface of the add-on structure 1.

Hydrophobic properties may be provided either by a hydrophobic coating or by providing a hydrophobic structure 7. The hydrophobic structure 7 works by giving outer surface of the add-on structure 1 a topography/shape with alternating ridges 8 and recesses respectively sized to jointly give hydrophobic properties as for example_ described in European Patent EP2474372A2. There are various feasible ways in which to provide a hydrophobic structure 7, but in the embodiments shown in fig. 8, space-apart ridges 8 of the hydrophobic structure 7 are formed in the host structure HS. In other embodiments, the hydrophobic structure 7 may alternatively be provided in a transparent or translucent layer 9 on the outside of the host structure HS as shown in the embodiments of figs. 7 and 9. In the embodiments of figs. 7-9, the ridges 8 protrude 80 - 120 µm from the bottom of the adjacent recess, wherein the width of the ridge 8 is 20-40 µm and the width of the recess is 50-100 µm spacing between ridges.
Forming the hydrophobic structure 7 in the host structure HS is space-efficient since no additional layer is needed for provision of the parallel spaced apart ridges 8 enabling the hydrophobic effect. Also, since no additional layer is needed, the number of steps of the manufacturing process are reduced.
Forming the hydrophobic structure 7 in a transparent or translucent layer on the outside of the host structure HS enables even thickness of the host structure HS and thereby an even upconversion and downconversion or downshifting effect over the extent of the add-on structure 1.

A hydrophobic coating may be provided by coating the outer surface of the add-on structure with a suitable hydrophobic compound 15. An example of such a suitable coating is a coating comprising hydrophobic silica nanoparticles and organosilica binders. The hydrophobic silica nanoparticle and organosilica binder-coating is especially advantageous in that it is anti-reflective.

It should be understood that it is possible to combine the use of a hydrophobic structure 7 with the provision of a hydrophobic coating 15 on the outer surface of the add-on structure 1.

### Microlens array

A microlens array may be provided in a microlens layer ML outside of the dopant(s) to concentrate incident radiation into the host structure HS containing the downconversion or downshifting dopant DD. By concentrating incoming radiation, the efficiency of the downconversion or downshifting dopant DD may be increased.

Any dopants which operate well without prior concentration of incoming solar radiation may however be used without microlenses. As of today, many known downconversion or downshifting dopants DD operate best with concentrated incoming solar radiation, i.e. the quantum yield of upconversion luminescence is non-linearly related to the intensity of excitation, therefore a two-fold increase intensity would result in at least a two-fold increase in the quantum yield of the upconverting luminophore. Spatially modulating light with microlens arrays would result in an increase of the upconverting quantum yield for the metamaterial.

The specific positioning of the microlenses of the microlens layer depend on the underlaying structure as evident from studying the embodiments of fig. 2 and of the ones of fig. 7-9. Microlenses are manufactured by any suitable manufacturing technology and they may be provided as a two-dimensional array of microlenses (convex). Alternatively, the microlenses may be provided in the form of elongate parallel ridges forming convex lenses.

### Wavelength-selective mirror

One or more wavelength-selective mirror layers 13, 14 may advantageously be provided to reflect radiation emitted by the dopants DD, UD in directions away from the photovoltaic cell 2 such that the reflected radiation is redirected towards the photovoltaic cell 2. Reflecting the radiation increases the amount of converted radiation reaching the photovoltaic cell 2. Preferably, the add-on structure 1 comprises both a first wavelength-selective mirror layer 13 configured for reflecting the emission peak wavelengths of the downconversion or downshifting dopant DD, and a second wavelength-selective mirror layer 14 configured for reflecting emission peak wavelengths of the upconversion dopant UD, as for example in the embodiments shown in figs. 10 and 11 where the two wavelength-selective mirror layers 13, 14 are provided separate from each other. Alternatively, the two wavelength-selective mirror layers 13, 14 can both be provided outside of both dopant types wherein the two mirror layer layers 13, 14 may be provided stacked on each other as shown in figs. 3-6. Alternatively, only one of the wavelength-selective mirror layers 13, 14 may be provided in the add-on structure 1, however reducing the ability of the add-on structure to reflect radiation of specific wavelengths back towards the photovoltaic cell as compared to using two wavelength-selective mirror layers adapted for reflecting different ranges of wavelengths.
Also, it should be understood that peak emission wavelengths are ranges of wavelengths unique to the respective dopant compound of choice, as the skilled person will understand. Typically, peak emission wavelengths are measure by the wavelength corresponding to their maximum intensity, and the FWHM (full-width at half maximum), which describes the width of the emission curve. Studying the emission characteristics of the dopant(s) of choice reveals what would be the range of wavelengths of peak emission.

### General considerations

The choice of compounds and the configuration for the various layers and dopants depend on the nature of the photovoltaic cell/panel 2 for which the add-on structure 1 is designed. Typically, the compounds involved (dopants, host matrix, wavelength-selective mirror layer, etc.) are adapted such that the spectrum of light emitted by the add-on structure 1 towards the photovoltaic cell/panel 2 is optimized for increased efficiency of energy conversion of the photovoltaic cell/panel 2 based on the composition of incident (solar) radiation.

### Exemplary embodiment

A first embodiment of add-on structure 1 and a method of producing the add-on structure 1 will hereinafter be described with reference to figs. 9 and 10.

The add-on structure 1 comprises a host structure HS comprising an upconversion dopant UD and a downconversion or downshifting dopant DD.

The host structure HS comprises an outer layer 5 with the downconversion or downshifting dopant DD, and an inner layer 6 with the upconversion dopant UD. Further, the downconversion or downshifting dopant DD is chosen to downconvert or downshift incident UV-light.

Each respective one of the inner layers 6 and the outer layer 5 of the host structure HS comprises a matrix substance 10 in/on which the respective dopants UD, DD is provided. The downconversion or downshifting dopant is Si QDs or CdS-CdSe (core-shell chalcogenide QDs), the upconversion dopant UP is lanthanide doped upconverting nanoparticles and the matrix substance 10 is PMMA comprising an encapsulant for the upconversion dopant, but those may alternatively be replaced by other suitable compounds as necessary.

The add-on structure 1 also comprises an anti-reflective layer 15 provided on an outside of the add-on structure 1 for receiving incident radiation before it reaches the rest of the add-on structure 1.

The anti-reflective layer 15 comprises hydrophobic silica nanoparticles and organosilica binders.

A microlens layer ML provided on the outer side 4 of the host structure HS, wherein the microlens layer ML is configured to concentrate incident light into the host structure HS as indicated in fig. 11.

The microlens layer ML comprises an array of microlenses in the form of parallel ridges 11 shaped for concentration of light into the host structure HS.

The add-on structure 1 further comprises a first wavelength-selective mirror layer 13 adapted for reflecting emission peak wavelengths of the downconversion or downshifting dopant DD. The first wavelength-selective mirror layer 13 is provided outside of the downconversion or downshifting dopant DD for reflecting radiation from the downconversion or downshifting dopant DD towards the photovoltaic cell 2. In this embodiment the first wavelength-selective mirror layer 13 is provided on a first glass substrate 16. The microlens array is provided on the outside of the first wavelength-selective mirror layer 13. Hence, the first wavelength-selective mirror layer 13 is provided in the microlens layer ML but the first wavelength-selective mirror layer 13 could alternatively in other embodiments be provided on a separate glass substrate between the downconversion or downshifting dopant DD and the microlens layer ML.

The add-on structure 1 further comprises a second wavelength-selective mirror layer 14 adapted for reflecting emission peak wavelengths of the upconversion dopant UD. The second wavelength-selective mirror layer 14 is provided outside of the inner layer 6 comprising the upconversion dopant UD for reflecting radiation emitted from the upconversion dopant UD back towards the photovoltaic cell 2. In this embodiment, the second wavelength-selective mirror layer 14 is formed on a second glass substrate 17 of the outer layer 5 of the host structure HS, wherein the matrix substance and the downconversion or downshifting dopant DD is provided on the outer surface of the second wavelength-selective mirror layer 14. Hence, the second wavelength-selective mirror layer 14 is provided between the layers comprising the downconversion or downshifting dopant DD and the upconversion dopant UD. The upconversion dopant UD and its associated matrix substance is provided on a third glass substrate 12 between the photovoltaic cell 2 and the second glass substrate 17.

The assembled add-on structure 1 is shown in fig. 10 with its layers stacked.

### Production method

Although the skilled person would be able to realize many ways in which to manufacture the above-described add-on structures 1, an exemplary method for forming the add-on structure 1 depicted in figs. 9-10 will be described below.

A third glass substrate 12 is provided with an upconversion layer comprising a matrix substance 10 and an upconversion dopant UD distributed in the matrix substance 10. The matrix substance 10 is applied to the third glass substrate 12 using by doctor blade coating or some other suitable method.

A second glass substrate 17 is provided with a second wavelength-selective mirror layer 14, for example formed according to principles discussed in US patent application US20110164308A1 or using some other suitable method. The first wavelength selective mirror layer 14 is configured for reflecting peak wavelengths of the upconversion dopant UD. In this embodiment, the upconversion dopant UD is lanthanide doped upconverting nanoparticles, as mentioned above.

A downshifting or downconversion layer for UV emission is provided by forming a downconversion or downshifting layer on the outer surface of the second wavelength-selective mirror layer 14, said downshifting or downconversion layer comprising a matrix substance 10 doped with a suitable downconversion or downshifting dopant DD, here Si QDs or CdS-CdSe (core-shell chalcogenide QDs). The matrix substance 10 should preferably be highly transparent to visible light and near-infrared light. In this example, polycarbonate is used as matrix substance but other suitable most matrix materials could alternatively be used instead. The matrix substance 10 of the downconversion or downshifting layer is either doctor bladed onto the second glass substrate 17 on top of the second wavelength selective mirror layer 14, or separately formed as an independent layer stacked with the other layers as shown in figs. 9-10.

A first glass substrate 16 is provided with a first wavelength selective mirror layer 13. The first wavelength selective mirror layer 13 is configured for reflecting peak wavelengths of the downconversion or downshifting dopant DD.

A microlens array is formed on the first wavelength selective mirror layer 13. In this example, the microlens array comprises parallel ridges (11) shaped for concentration of light into the host structure HS, preferably focused into the outer layer comprising the downconversion or downshifting dopant DD. The microlens array is formed using a mold in which polycarbonate or downshifting doped polymer (PMMA), or downshifting-upconverting doped polymer (PMMA) is molded to form the microlens array. Instead of using a mold, any other suitable method of forming the microlens array may alternatively be used instead. The first glass substrate and its first wavelength-selective mirror layer 13 is then joined with the molded microlens array to form the joint structure shown in the upper portion of Fig. 9.

The mold is produced using multi-step photolithography according to the principles outlined by Choi and Park in "Two-step photolithography to fabricate multilevel microchannels"
(https://www.ncbi.nlm.nih.gov/pmc/articles/PMC2998036/). However, it should be understood that any other suitable method of forming the mold alternatively could be used instead. Also, instead of parallel ridges of elongate lenses, a two-dimensional microlens array may alternatively be provided instead. Further, instead of using a mold, the microlenses could be formed using any suitable method.

After formation of the microlens array, a hydrophobic and anti-reflective layer 15 is provided on the microlens array by spray coating or dip-coating hydrophobic silica nanoparticles and organosilica binders to form a coating exhibiting both hydrophobic and anti-reflective properties.
The method for applying the hydrophobic + antireflective layer is the one explained by Chi et al 2019 "Mechanically robust and self-cleaning antireflection coatings from nanoscale binding of hydrophobic silica nanoparticles". However, any suitable method of adding the anti-reflection coating could alternatively be used instead.

The final add-on structure 1 is formed by stacking the glass substrates 16, 17, 12 and associated layers as shown in fig. 10.

The first 16, second 17 and third 12 glass substrates are joined by a suitable transparent adhesive but could alternatively or additionally be joined by a frame or other suitable fixture.

The method of producing the add-on structure 1 is adapted to the specific embodiments of add-on structure 1 to be produced and may for example comprise an additional step of providing a hydrophobic structure 7 somewhere inside of/inside the microlens layer, for example like any one of the hydrophobic structures 7 schematically shown in figs. 7-9.

### Further embodiments

A second embodiment of the add-on structure 1 is shown in fig. 1. The add-on structure 1 comprises a host structure HS comprising a matrix substance doped with both upconversion dopant UD and downconversion or downshifting dopant DD.
The embodiments of figs. 2-5 are similar to the second embodiment but also comprise at least a microlens layer ML with a microlens array. The embodiment of fig. 3 comprises a wavelength-selective mirror layer provided on the outside of the microlens array. The embodiment of fig. 4 is similar to the one of fig. 3 but has the wavelength-selective mirror layer provided between the host structure HS and the microlens array. The embodiment of fig. 5 is similar to the one of fig. 3 but further comprises an anti-reflective and hydrophobic layer on the outside of the wavelength-selective mirror layer. The embodiment of fig. 6 is similar to the one of fig. 4 but further comprises an anti-reflective layer on the outside of the wavelength-selective mirror layer.

## Claims

1. An add-on structure (1) for a photovoltaic cell, wherein said add-on structure (1) is for being positioned between incident radiation and the photovoltaic cell (2), and wherein said add-on structure (1) comprises a host structure (HS) comprising an upconversion dopant (UD) and a downconversion or downshifting dopant (DD).

2. An add-on structure (1) according to claim 1, wherein the host structure (HS) comprises an outer layer (5) with the downconversion or downshifting dopant (DD), and an inner layer (6) with the upconversion dopant (UD), and wherein the downconversion or downshifting dopant (DD) is chosen to downconvert or downshift incident UV-light.

3. An add-on structure (1) according to any one of claims 1- 13, further comprising an anti-reflective layer (15) provided on an outside of the add-on structure for receiving incident radiation before it reaches the rest of the add-on structure (1).

4. An add-on structure (1) according to claim 14, wherein the anti-reflective layer (15) comprises hydrophobic silica nanoparticles and organosilica binders.

5. An add-on structure (1) according to any one of claims 1 to 4, further comprising a hydrophobic structure (7) comprising parallel spaced-apart ridges (8), said ridges being sized and spaced-apart such that they provide hydrophobic properties to the add-on structure (1).

6. An add-on structure (1) according to claim 5, wherein the spaced-apart ridges (8) of the hydrophobic structure (7) are formed in the host structure (HS).

7. An add-on structure (1) according to claim 5, wherein the spaced-apart ridges (8) of the hydrophobic structure (7) are provided in a transparent or translucent layer (9) on the outside of the host structure (HS).

8. An add-on structure (1) according to any one of claims 1 to 7, wherein the downconversion or downshifting dopant (DD) is chosen from a first group comprising:
• organosilane-functionalized carbon nano dots (Si-CNDs) crosslinked in the siloxane matrix,
• core-shell chalcogenide quantum dots (Cds/CdSe), and
• CulnS2/ZnS quantum dots,
wherein the upconversion dopant (UD) is chosen from a second group comprising:
• nitrogen doped graphene quantum dots
• lanthanide-doped upconversion nanoparticles, and
• fluorescent semiconducting nanocrystals, and
wherein the host structure (HS) comprises a matrix substance (10) in which the downconversion or downshifting dopant (DD) and any upconversion dopant (UD) is embedded, wherein the matrix substance is chosen from a third group comprising:
• P(LMA-co-EGDMA),
• PMMA, and
• PVA.

9. An add-on structure (1) according to claim 8, wherein the downconversion or downshifting dopant (DD) is organosilane-functionalized carbon nano dots (Si-CNDs) crosslinked in the siloxane matrix, wherein the upconversion dopant (UP) is nitrogen doped graphene quantum dots, and wherein the matrix substance (10) is PMMA.

10. An add-on structure according to any one of claims 1 to 9, further comprising a microlens layer (ML) provided on the outer side (4) of the host structure (HS), wherein the microlens layer (ML) is configured to concentrate incident light into the host structure (HS).

11. An add-on structure (1) according to claim 10 when dependent directly or indirectly on any one of claims 5 to 7, wherein the microlens layer (ML) is provided on an outer surface of the hydrophobic structure (7).

12. An add-on structure (1) according to any one of claims 10 or 11, wherein the microlens layer (ML) comprises an array of microlenses in the form of parallel ridges (11) shaped for said concentration of light into the host structure (HS).

13. An add-on structure (1) according to any one of claims 10 or 11, wherein the microlens layer (ML) comprises a two-dimensional array (12) of microlenses.

14. An add-on structure (1) according to any one of claims 1-13 further comprising a first wavelength-selective mirror layer (13) adapted for reflecting emission peak wavelengths of the downconversion or downshifting dopant (DD), wherein the first wavelength-selective mirror layer (13) is provided outside of the downconversion or downshifting dopant for reflecting radiation from the downconversion or downshifting dopant towards the photovoltaic cell.

15. An add-on structure (1) according to any one of claims 1-14 further comprising a second wavelength-selective mirror layer (14) adapted for reflecting emission peak wavelengths of the upconversion dopant (UD), wherein the second wavelength-selective mirror layer (14) is provided outside of the layer comprising the upconversion dopant (UD) for reflecting radiation from the upconversion dopant (UD) towards the photovoltaic cell.

## Amended claims

### Amended claims in accordance with Rule 137(2) EPC.

1. An assembly comprising a photovoltaic cell (2) and an add-on structure (1), wherein said add-on structure (1) is configured to, during use, be positioned between incident radiation and the photovoltaic cell (2), and wherein said add-on structure (1) comprises a host structure (HS) comprising an upconversion dopant (UD) and a downconversion or downshifting dopant (DD), wherein the host structure (HS) comprises an outer layer (5) with the downconversion or downshifting dopant (DD), and an inner layer (6) with the upconversion dopant (UD), and wherein the downconversion or downshifting dopant (DD) is chosen to downconvert or downshift incident UV-light **characterized in that** said outer layer (5) faces away from the photovoltaic cell (2) and **in that** said inner layer (6) faces the photovoltaic cell (2).

2. An assembly according to claim 1, further comprising an anti-reflective layer (15) provided on an outside of the add-on structure for receiving incident radiation before it reaches the rest of the add-on structure (1).

3. An assembly according to claim 2, wherein the anti-reflective layer (15) comprises hydrophobic silica nanoparticles and organosilica binders.

4. An assembly according to any one of claims 1 to 3, further comprising a hydrophobic structure (7) comprising parallel spaced-apart ridges (8), said ridges being sized and spaced-apart such that they provide hydrophobic properties to the add-on structure (1).

5. An assembly according to claim 4, wherein the spaced-apart ridges (8) of the hydrophobic structure (7) are formed in the host structure (HS).

6. An assembly according to claim 4, wherein the spaced-apart ridges (8) of the hydrophobic structure (7) are provided in a transparent or translucent layer (9) on the outside of the host structure (HS).

7. An assembly according to any one of claims 1 to 6, wherein the downconversion or downshifting dopant (DD) is chosen from a first group comprising:
• organosilane-functionalized carbon nano dots (Si-CNDs) crosslinked in the siloxane matrix,
• core-shell chalcogenide quantum dots (Cds/CdSe), and
• CuInS2/ZnS quantum dots,
wherein the upconversion dopant (UD) is chosen from a second group comprising:
• nitrogen doped graphene quantum dots
• lanthanide-doped upconversion nanoparticles, and
• fluorescent semiconducting nanocrystals, and
wherein the host structure (HS) comprises a matrix substance (10) in which the downconversion or downshifting dopant (DD) and any upconversion dopant (UD) is embedded, wherein the matrix substance is chosen from a third group comprising:
• P(LMA-co-EGDMA),
• PMMA, and
• PVA.

8. An assembly according to claim 7, wherein the downconversion or downshifting dopant (DD) is organosilane-functionalized carbon nano dots (Si-CNDs) crosslinked in the siloxane matrix, wherein the upconversion dopant (UP) is nitrogen doped graphene quantum dots, and wherein the matrix substance (10) is PMMA.

9. An assembly according to any one of claims 1 to 8, further comprising a microlens layer (ML) provided on the outer side (4) of the host structure (HS), wherein the microlens layer (ML) is configured to concentrate incident light into the host structure (HS), wherein the outer side (4) of the host structure faces away from the photovoltaic cell.

10. An assembly according to claim 9 when dependent directly or indirectly on any one of claims 4 to 6, wherein the microlens layer (ML) is provided on an outer surface of the hydrophobic structure (7), wherein the outer surface faces away from the photovoltaic cell (2).

11. An assembly according to any one of claims 9 or 10, wherein the microlens layer (ML) comprises an array of microlenses in the form of parallel ridges (11) shaped for said concentration of light into the host structure (HS).

12. An assembly according to any one of claims 9 or 19, wherein the microlens layer (ML) comprises a two-dimensional array (12) of microlenses.

13. An assembly according to any one of claims 1-12 further comprising a first wavelength-selective mirror layer (13) adapted for reflecting emission peak wavelengths of the downconversion or downshifting dopant (DD), wherein the first wavelength-selective mirror layer (13) is provided outside of the downconversion or downshifting dopant for reflecting radiation from the downconversion or downshifting dopant towards the photovoltaic cell, wherein the outside of the downconversion or downshifting dopant faces away from the photovoltaic cell (2).

14. An assembly according to any one of claims 1-13 further comprising a second wavelength-selective mirror layer (14) adapted for reflecting emission peak wavelengths of the upconversion dopant (UD), wherein the second wavelength-selective mirror layer (14) is provided outside of the layer comprising the upconversion dopant (UD) for reflecting radiation from the upconversion dopant (UD) towards the photovoltaic cell, wherein the outside of the layer comprising the upconversion dopant (UD) faces away from the photovoltaic cell (2).
